(19) Europäisches Patentamt / European Patent Office / Office européen des brevets

(11) **EP 2 200 418 A2**

(12) **EUROPEAN PATENT APPLICATION**

(43) Date of publication:
**23.06.2010 Bulletin 2010/25**

(51) Int Cl.:
**H05K 13/04** *(2006.01)*

(21) Application number: **09015741.3**

(22) Date of filing: **18.12.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **22.12.2008 JP 2008325695**

(71) Applicant: **Hitachi High-Tech Instruments Company, Ltd.**
**Kumagaya-shi**
**Saitama 360-0238 (JP)**

(72) Inventors:
• **Takagi, Yuji**
**Tokyo 100-8220 (JP)**
• **Takemura, Ikuo**
**Tokyo 100-8220 (JP)**

(74) Representative: **Strehl Schübel-Hopf & Partner**
**Maximilianstrasse 54**
**80538 München (DE)**

(54) **Method and apparatus for mounting electronic components**

(57)    An electronic component mounting apparatus that includes a component mounting head, a camera for acquiring an image of an electronic component, and an image processing unit for executing distortion correction of the acquired electronic-component image, based upon distortion correcting data, and then recognizing a position of the electronic component on the basis of the image upon which the distortion correction has been conducted, is constructed so that a distortion correcting jig on which is formed a distortion correcting pattern defined in an (x, y) coordinate system is retained by the component mounting head, and so that after the (x, y) coordinate system with the distortion correcting pattern defined therein has been rotated through a predetermined angle with respect to an (I, J) coordinate system defined on an imaging surface of the camera, the image processing unit calculates the distortion correcting data on the basis of an image of the distortion correcting pattern, acquired during pattern imaging with the camera.

FIG.1

EP 2 200 418 A2

**Description**

Background

The present invention relates generally to apparatus for mounting electronic components on a printed circuit board by use of a components mounting head traveling in X-and Y-directions. More particularly, the invention concerns a method for correcting any image distortion arising from lens distortion and an attitude of a component position recognizing camera when the camera recognizes a position of a component prior to mounting of the component.

Of all cameras used for measuring the positions of workpieces such as circuit boards and electronic components, those which require particularly high position-measuring accuracy in electronic components mounting apparatus are corrected for image distortion due to the camera lens.

Methods of correcting any image distortion on an imaging screen are described in, for example, Patent Document 1 (JP-A-6-241724) and Non-Patent Document 1 (Hirofumi Chikatsu, Yoichi Kunii, and Ryuji Nakata, "Verification of the 3-million-pixel digital still camera accuracy as viewed in terms of digital photogrammetry", Photogrammetry and Remote Sensing, Vol. 40, No. 2, 2001, pp. 33-38). Both methods described in the above documents include the steps of imaging a plurality of standard objects distributed at predetermined pitches on a standard surface, extracting the plurality of standard object images on the imaging screen, calculating gravitational positions of the extracted standard object images, allocating reference coordinates predetermined for the standard objects on the standard surface, to the gravitational positions of the standard objects, assigning each gravitational position and the allocated respective reference coordinates to a conversion expression for converting the coordinates on the imaging screen into calibrated coordinates, calculating a plurality of constants of the conversion expression in order to define association between the gravitational position and the allocated appropriate reference coordinates, and storing results into memory means.

Summary

In the above Patent Document 1, although a calibration procedure relating to image distortion is disclosed, no description is given of a method for stabilizing calibration results by suppressing a quantization error due to imaging. For this reason, the calibration method described in Patent Document 1 has the problems that different calibration results are produced with each calibration of the distortion, and thus that the position measurement using the distortion correction data makes difficult in performing highly reproducible measurement.

In order to solve the above problems, the present invention provides an electronic component mounting apparatus that recognizes with high accuracy a position of an electronic component suction-held by a suction nozzle of a component mounting head, by use of a CCD-based or MOS-based sensor type of camera beset with a quantization error, and consequentially achieves a high level of mounting-position accuracy. The invention is also intended to provide a method for correcting any image distortion arising from lens distortion and an attitude of a component position recognizing camera when the camera recognizes a position of a component prior to mounting of the component.

More specifically, one aspect of the present invention is an electronic component mounting apparatus, comprising; a component mounting head with a suction nozzle for holding an electronic component by suction, the mounting head being adapted to move in an X-direction and a Y-direction; a component position recognizing camera for acquiring an image of the electronic component suction-held by the suction nozzle of the component mounting head, by imaging the electronic component on an imaging surface defined in an (I, J) coordinate system; and an image processing unit adapted to conduct a distortion correction based upon distortion correcting data (constants k1, k2, k3, etc.) stored within a storage unit after being arithmetically obtained for the image of the electronic component that is acquired from the component position recognizing camera, and thereby recognize a position of the electronic component on the basis of the image subjected to the distortion correction; wherein: a distortion correcting jig on which is formed a distortion correcting pattern defined in an (x, y) coordinate system is retained by the component mounting head; and after the (x, y) coordinate system with the distortion correcting pattern defined therein has been rotated or inclined through a predetermined angle with respect to the (I, J) coordinate system defined on the imaging surface of the component position recognizing camera, the image processing unit calculates the distortion correcting data on the basis of an image of the distortion correcting pattern, acquired during pattern imaging with the component position recognizing camera, and then stores the calculated data into the storage unit.

Preferably, when the distortion correcting data in the present invention is calculated from the distortion correcting pattern image acquired during pattern imaging with the component position recognizing camera in the offset state of its quantization error, the image processing unit uses least squares approximation to conduct the distortion correcting data calculation upon a sequence of orthogonal grid points on the distortion correcting pattern.

Preferably, the electronic component mounting apparatus in the present invention further comprises control means adapted such that when the distortion correcting pattern is imaged with the component position recognizing camera, the control means controls the (x, y) coordinate system to rotate, with the distortion correcting pattern defined therein, through the predetermined angle with respect to the (I, J) coordinate system defined on the imaging surface of the component position recognizing camera. Furthermore, the control means includes a motor that rotates the component mounting head about a vertical axis thereof with the distortion correcting jig retained by the mounting head.

Preferably, in the present invention, an outside-dimensional reference rotated through the predetermined angle relative to the (x, y) coordinate system having the distortion correcting pattern defined therein is formed for the distortion correcting jig and the distortion correcting jig is retained with the formed outside-dimensional reference positioned at the component mounting head.

Preferably, the distortion correcting pattern in the present invention is formed with a point-symmetric graphic or x-y directionally line-symmetric graphic disposed on a grid point sequence defined in the (x, y) coordinate system. Preferably, the component position recognizing camera in the present invention is constructed using a CCD-based sensor or a MOS-based sensor.

Another aspect of the present invention is a method for mounting an electric component on a circuit board, comprising the steps of: holding an electronic component by suction with a component mounting head; acquiring an image of the electronic component suction-held by the component mounting head with a component position recognizing camera; conducting a distortion correction, based upon distortion correcting data stored in a memory, of the image of the electronic component acquired from the component position recognizing camera; recognize a position of the electronic component suction-held by the component mounting head on the basis of the image subjected to the distortion correction; and mounting the electronic component on a circuit board by correcting the position of the electronic component suction-held by the component mounting head by using information obtained by the recognizing, wherein in the step of conducting a distortion correction, said distortion correction data is obtained by rotating a (x, y) coordinate system of a distortion correcting pattern formed on a distortion correcting jig suction-held by the component mounting head with respect to a (I, J) coordinate system defined on an imaging surface of the camera through a predetermined angle; calculating the distortion correction data from an image of the distortion correction pattern obtained by the component position recognizing camera; and storing the distortion correction data in a memory.

These features and advantages of the invention will be apparent from the following more particular description of preferred embodiments of the invention, as illustrated in the accompanying drawings.

Brief Description of the Drawings

Fig. 1 is a plan view showing a schematic configuration of a first embodiment of an electronic component mounting apparatus according to the present invention;

Fig. 2 is a block diagram showing a system configuration of the first embodiment of the electronic component mounting apparatus according to the present invention;

Fig. 3 is an explanatory diagram of a data table for mounting components according to the present invention;

Fig. 4 is a flowchart that shows component mounting in the first embodiment of the electronic component mounting apparatus according to the present invention;

Fig. 5 is a structural view that shows a peripheral region of a component position recognizing camera existing during calculation of distortion correcting data in the first embodiment of the electronic component mounting apparatus according to the present invention;

Fig. 6 illustrates an example of a distortion correcting jig in the first embodiment of the electronic component mounting apparatus according to the present invention;

Fig. 7 illustrates variants of a pattern formed on the distortion correcting jig shown in Fig. 6;

Fig. 8 is a flow diagram that shows a distortion correcting process sequence, inclusive of image processing for distortion correction in the first embodiment of the electronic component mounting apparatus according to the present invention;

Fig. 9 is a diagram that shows experimental results obtained when the distortion correcting jig according to the present invention is moved through 120 pm at 5-$\mu$m itches in an 1-direction of image coordinates and then a gravitational position of one circularly marked point on the distortion correcting jig is measured with a camera of 60-$\mu$m image resolution;

Fig. 10 is a diagram that shows the same experimental results as those of Fig. 9, with a horizontal axis denoting the same as in Fig. 9, and with a vertical axis denoting differences in distance between an approximate line of Fig. 9 and various measuring positions;

Fig. 11 is a diagram that represents a relationship between an (x, y) coordinate system of the distortion correcting jig according to the present invention, and an (I, J) coordinate system of an image acquired during imaging with a camera;

Fig. 12 is a diagram that explains a quantization error in pattern detection position, caused when the (x, y) coordinate system of the distortion correcting jig according to the present invention is rotated with respect to the (I, J) coordinate system of the image acquired during imaging with the camera;

Fig. 13 is a diagram that represents a relationship between the distortion correcting jig imaged with the camera according to the present invention, and a distortion correcting region specified in the image;

Fig. 14 is an operational flowchart that shows process steps in the first embodiment of the electronic component mounting apparatus according to the present invention;

Fig. 15 is a structural view that shows a peripheral region of a component position recognizing camera existing during calculation of distortion correcting data in a second embodiment of an electronic component mounting apparatus according to the present invention;

Fig. 16 illustrates an example of a distortion correcting jig in the second embodiment of the electronic component mounting apparatus according to the present invention; and

Fig. 17 is a flow diagram that shows a distortion correcting process sequence in the second embodiment of the electronic component mounting apparatus according to the present invention.

Description of The Preferred Embodiments

(First Embodiment)

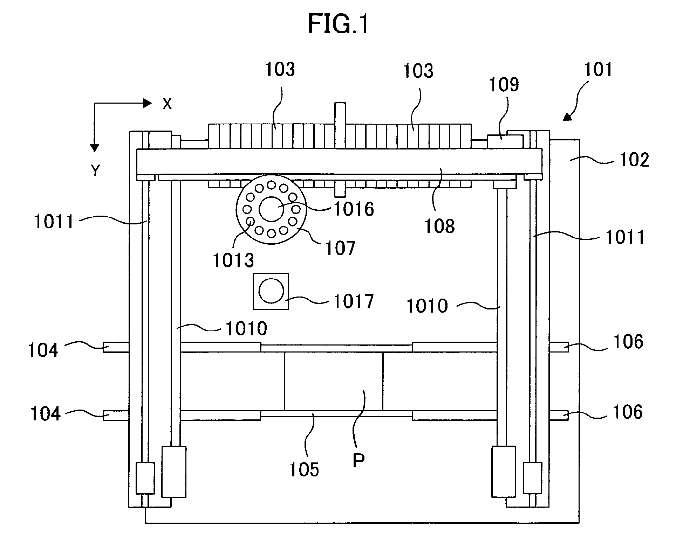

A first embodiment of an electronic component mounting apparatus according to the present invention is described below using Figs. 1 to 14.

Fig. 1 is a plan view showing a configuration of the electronic component mounting apparatus 101 according to the present invention, with a plurality of component feeder units 103 arranged next to one another on a base 102 of the electronic component mounting apparatus 101 in order to supply various electronic components, one at a time, to respective component-unloading portions (component suction positions). A supply conveyor 104, a positioning unit 105, and an unloading conveyor 106 are provided for a printed circuit board P. The supply conveyor 104, after receiving a printed circuit board P from an upstream side, carries the printed circuit board P to the positioning unit 105, which then positions the board P via a positioning mechanism (not shown). After this, the electronic components are mounted on the positioned board P and then further carried to the unloading conveyor 106.

A beam 108 elongated in an X-direction is constructed so that when a Y-axis motor 109 is driven, screw shafts 1010 rotate and the beam 108 moves in a Y-direction between a position above the printed circuit board P, and another position above the component-unloading portion (component suction position) of the appropriate component feeder unit 103, along one pair of guides 1011 located at left and right sides. A component mounting head 107 is provided on the beam 108 so that when an X-axis motor 1012 (not shown) is driven, the head 107 moves in a lateral direction thereof, that is, the X-direction, along a guide (not shown). The component mounting head 107 itself has 12 up/down shaft motors 1014 (not shown) to move 12 respective suction nozzles 1013 upward and downward. The component mounting head 107 also includes 12 θ-axis motors 1015 (not shown) to rotate the 12 suction nozzles 1013 about respective perpendicular axes. Therefore, the 12 suction nozzles 1013 of the component mounting head 107 can each be moved in the X- and Y-directions with the movements of the component mounting head 107 in the X- and Y-directions, then rotated about the perpendicular axis, and moved upward and downward. In addition, the component mounting head 107 has a separate θ-axis motor 1016, which makes the head 107 circularly rotatable about its vertical axis.

The component position recognizing camera 1017 for recognizing a position of an electronic component suction-held by each suction nozzle 1013 of the component mounting head 107 is provided on the base 102 of the electronic component mounting apparatus 101. That is to say, the apparatus 101 first activates the component position recognizing camera 1017 to image the electronic component suction-held by the suction nozzle 1013, in an (I, J) coordinate system of the camera, and acquire the image of the electronic component. Next, the apparatus 101 activates an image processing unit 2011 or the like to conduct image distortion correction using a expression (1) described later herein, upon the electronic component image acquired from the component position recognizing camera 1017. The image distortion correction is based upon precalculated distortion correcting data (constants k1, k2, k3, etc.) stored within a RAM (storage unit) 202. Upon completion of the image distortion correction, the camera 1017 uses the image in an (x, y) coordinate system that has undergone the correction process, to recognize the position of the electronic component in terms of XY coordinates and rotational angle. The camera 1017 thus discriminates a shift in the position of the suction-held electronic component with respect to the suction nozzle 1013.

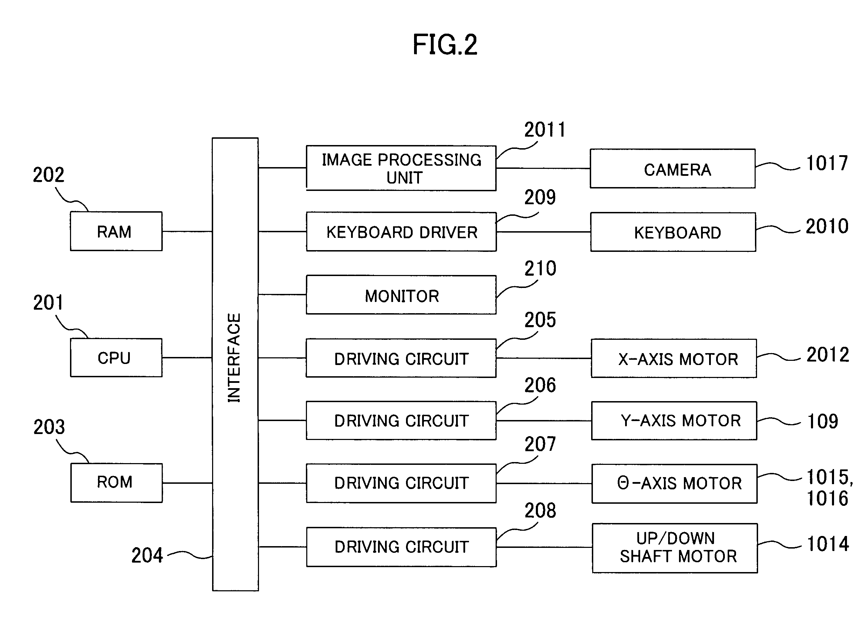

Fig. 2 is a control block diagram of the electronic component mounting apparatus 101 according to the present invention. The X-axis motor 1012 is a rotational driving source for moving the component mounting head 107 in the X-direction along the guide on the beam 108. The Y-axis motor 109 is a rotational driving source for moving the beam 108 in the Y-direction along the left/right pair of guides 1011. The θ-axis motor 1016 is a rotational driving source for rotating the component mounting head 107 about the vertical axis. The θ-axis motors 1015 are each a rotational driving source for rotating the appropriate suction nozzle 1013 about the perpendicular axis. The up/down shaft motors 1014 are each a rotational driving source for moving the appropriate suction nozzle 1013 upward and downward. The following description assumes that one X-axis motor 1012, one Y-axis motor 109, one θ-axis motor 1015, one θ-axis motor 1016, and one up/down shaft motor 1014 are shown in each figure for convenience' sake.

Reference number 201 denotes a CPU (central processing unit) that operates as a control unit for undertaking integrated control of the electronic component mounting apparatus 101 according to the present invention. The CPU 201 also operates as an arithmetic unit. A random-access memory (RAM) 202 and a read-only memory (ROM) 203 are connected to the CPU 201 via a bus line. On the basis of data stored within the RAM 202, the CPU 201 conducts the integrated control of the component mounting operation of the electronic component mounting apparatus 101 in accordance with a program stored within the ROM 203.

That is to say, the CPU 201 conducts driving control of the X-axis motor 1012 via an interface 204 and a driving circuit 205, that of the Y-axis motor 109 via the interface 204 and a driving circuit 206, that of the θ-axis motor 1015, 1016 via the interface 204 and a driving circuit 207, and that of the up/down shaft motor 1014 via the interface 204 and a driving circuit 208.

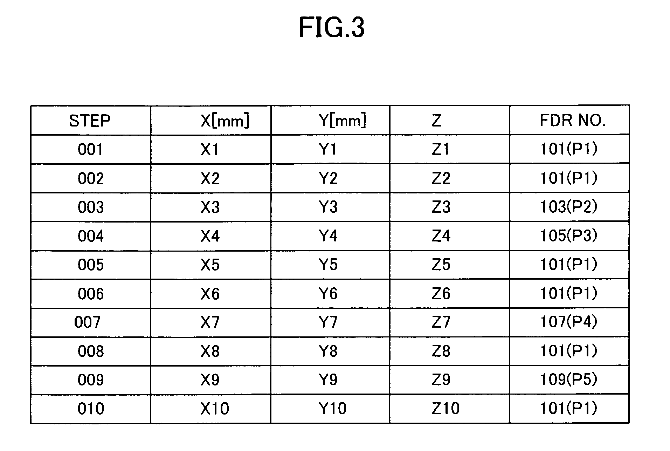

Such component-mounting data as shown in Fig. 3 is stored within the RAM 202. This data includes information on the in-board X-direction (denoted as X), Y-direction (denoted as Y), and angle (denoted as Z), for each mounting sequence (i.e., for each step number). The component-mounting data also includes disposition numbers of the component feeder units 3, each of the disposition numbers being denoted as "Fdr No." In addition, the component-mounting data includes information on the kind of electronic component, and other information. The disposition number 101, for example, indicates that the kind of electronic component is P1. Dimensions of the electronic component in the X- and Y-directions, and respective tolerances are further stored within the RAM 202, for each kind of electronic component.

Reference number 2011 denotes the image processing unit connected to the CPU 201 via the interface 204. The image processing unit 2011 processes the image that has been acquired during imaging by the camera 1017, and transmits processing results to the CPU 201. That is to say, the CPU 201 outputs to the image processing unit 2011 an instruction for processing the image acquired by the component position recognizing camera 1017. This processing instruction relates to, for example, calculating the amount of shift in the position of the electronic component suction-held by the suction nozzle 1013 of the component mounting head 107, or correcting any image distortion of the camera-acquired image in the (I, J) coordinate system. The CPU 201 also receives processing results from the image processing unit 2011.

Reference number 2010 denotes a keyboard that functions as a data registering device connected to the CPU 201 via a keyboard driver 209 and the interface 204. Reference number 210 denotes a monitor that displays the image of the component and other data. The keyboard 2010 as the data registering device, may be replaced by a touch panel or the like.

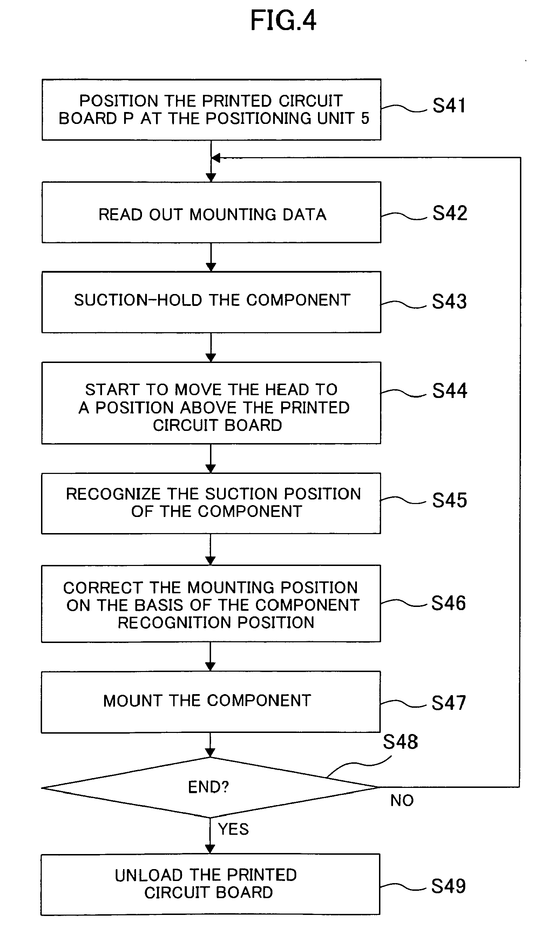

The component mounting operation in the above apparatus configuration is described below using Fig. 4. In a first step (S41), a conveyor (not shown) carries a printed circuit board P from an upstream device via the supply conveyor 104 to the positioning unit 105, at which the board P is then positioned and fixed by a positioning mechanism (not shown).

Next, in step S42, the CPU 201 reads out the mounting data (shown in Fig. 3) that is stored within the RAM 202, and then in step S43, reads out specified component-mounting XY coordinate positions on each printed circuit board P, specified rotational angle positions about the perpendicular axes which are rotational axes of the suction nozzles, specified disposition numbers, and other information, that were stored for each step number in the RAM 202. After this, the electronic components that each suction nozzle 1013 is to suction-hold are unloaded from the predetermined component feeder units 103 by suction. In other words, the component mounting head 107 moves to be positioned above each component feeder unit 103 for accommodation of each electronic component to be mounted. At this time, the driving circuit 206 drives the Y-axis motor 109 to move the beam 108 in the Y-direction along the paired guides 1011, and the driving circuit 205 drives the X-axis motor 1012 to move the component mounting head 107 in the X-direction on the beam 108. Next since each predetermined component feeder unit 103 has already been driven to make the components unloadable therefrom at the respective suction positions, the driving circuit 208 drives the up/down shaft motor 1014 to move each suction nozzle 1013 downward and unload each electronic component by suction.

Next, the suction nozzle 1013 that has been driven by the up/down shaft motor 1014 to suction-hold the electronic component moves upward, the beam 108 moves in the Y-direction along the paired guides 1011. In addition, the component mounting head 107 is driven by the X-axis motor 1012 to move in the X-direction along the guides 1011. Thus, the component mounting head 107 starts moving to a position above the printed circuit board P in step S44.

Above the component position recognizing camera 1017 moving in this way, the electronic component that has been suction-held by the suction nozzle of the component mounting head 107 is imaged in the (I, J) coordinate system by the camera 1017. In the image processing unit 2011, on the basis of the distortion correcting data (constants $k_1$, $k_2$, $k_3$, etc.) prestored within the RAM 202, for example, highly accurate correction of any image distortion due to both an attitude and lens distortion of the component position recognizing camera 1017 is conducted upon the image that the camera 1017 has acquired in the (I, J) coordinate system. The correction is based upon expression (1) described later herein. In step S45 that follows completion of the image distortion correction, the image in the (x, y) coordinate system is used to recognize the shift in the position of the suction-held electronic component with respect to the suction nozzle 1013, in terms of XY coordinates and rotational angle.

In step S46, on the basis of the thus-recognized shifts in the positions of each electronic component, the CPU 201 corrects the component-mounting XY coordinate positions, and rotational angle positions with respect to the perpendicular axis, that were stored for each step number in the RAM 202. Briefly, the X-axis motor 1012 and the Y-axis motor 109 are controlled via the driving circuits 205 and 206, respectively, to correct any shifts in the positions of the component in the XY directions, and the θ-axis motor 1015 is controlled via the driving circuit 207 to correct any shifts in the rotational angle of the component. In step S47, the component is thus mounted at a desired position on the printed circuit board P.

High accuracy is therefore required for the recognition of the component position, based upon the image acquired by the component position recognizing camera 1017. For this reason, the image distortion contained in the acquired image, the distortion being due to the camera attitude and lens distortion, requires highly accurate correction.

The above steps are sequentially executed for all components corresponding to such mounting data as recorded in Fig. 3, and in step S48, after all components have been mounted, the printed circuit board P is carried from the positioning unit 105 via the unloading conveyor 106 to a downstream device (step S49).

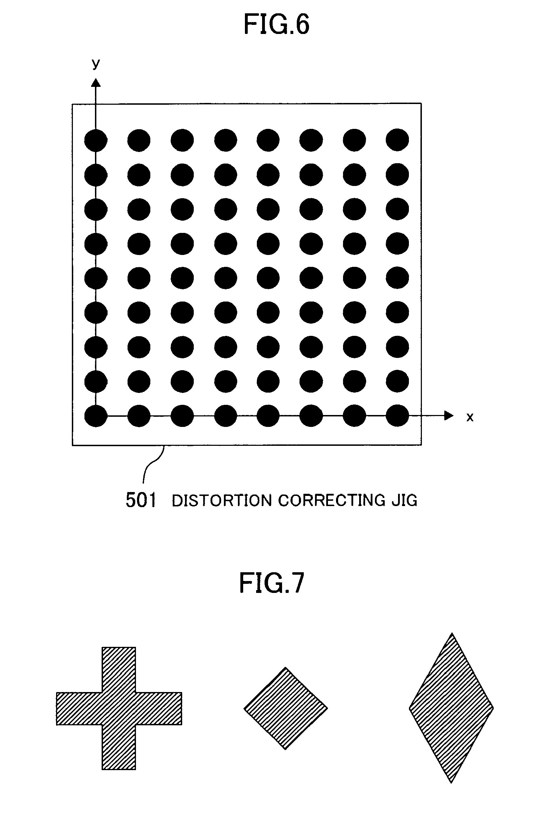

An example of precalculating data on the image distortion due to camera attitude and lens distortion, contained in the image acquired by the component position recognizing camera 1017, is described below. The imaging surface of the CCD or MOS sensor-based camera 1017 used for component position recognition in the electronic component mounting apparatus according to the present invention is constructed in spatially discretized pixel units. Position measurement with these sensors therefore causes a quantization error. Accordingly, when distortion due to a lens of the camera 1017 is corrected with a distortion correcting jig 501 having a pattern of dots or other marks on the grid points shown in Fig. 6, highly accurate correction will not be achievable since measurement results on positions of the dots on the grid points will be influenced by the quantization error for reasons such as a relative positional relationship between the sensor and the distortion correcting jig 501. In addition, since the relative positional relationship between the sensor and the distortion correcting jig 501 is difficult to maintain each time the correction is repeated, the correction results obtained will differ each time and consequently, even when the same object is measured, position measurement results will lack reproducibility. For these reasons, electronic component mounting apparatus that has undergone such corrections has had the problem that components cannot be mounted with high accuracy.

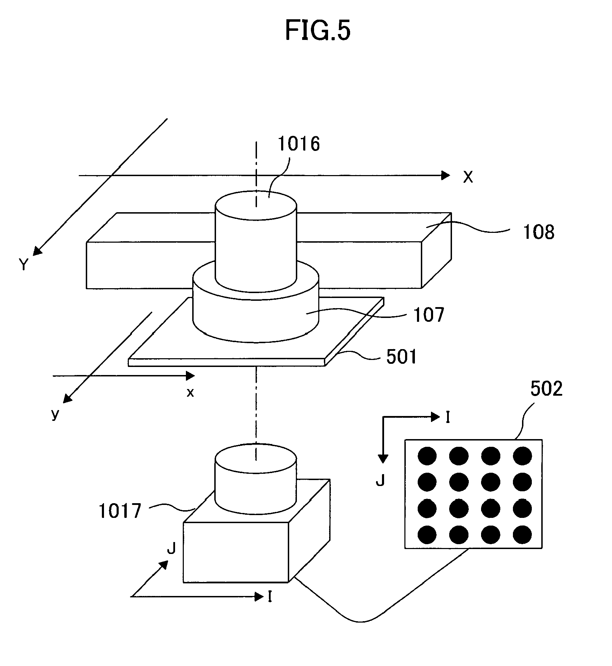

Accordingly, an example of implementing the highly accurate correction of distortion that is free from any impacts of a quantization error, is next described below. Fig. 5 is a structural view that shows the component position recognizing camera 1017 in calculating the distortion correcting data according to the present invention. As shown in example 502 of an image acquired by the camera 1017, the coordinates on the camera-acquired image are defined as I in a rightward direction of a horizontal axis, and as J in a downward direction of a vertical axis. The distortion correcting jig 501 is removably retained by the component mounting head 107. Fig. 6 shows an example of the distortion correcting jig 501. On the distortion correcting jig 501, marks are arranged at orthogonal grid points defined in an (x, y) coordinate system. All adjacent marks (circles) are arranged at constant, known intervals. Although circles are shown as the marks in the example of Fig. 6, these marks can be other than circles, only if a point-symmetrical pattern is formed, or an x-y axially line-symmetrical graphic can be disposed on each orthogonal grid point, as with the crisscross mark or diamond-shaped or rhomboid mark shown in Fig. 7. The suction head 107 rotates by means of the θ-axis motor 1016. Also, the suction head 107 and the θ-axis motor 1016 move in the X-direction along the beam 108, as described in Fig. 1, and move in the Y-direction along the guides 1011 shown in Fig. 1.

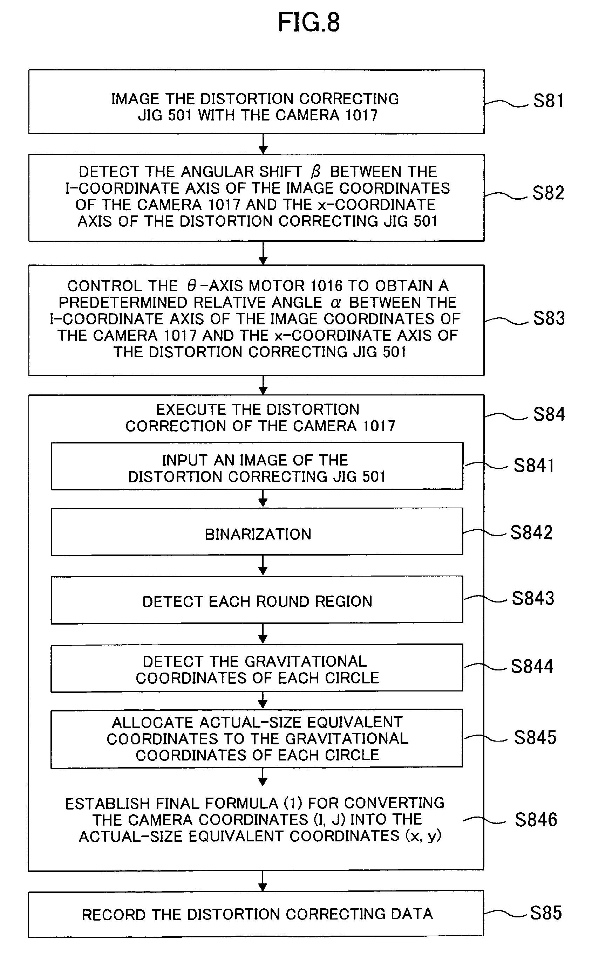

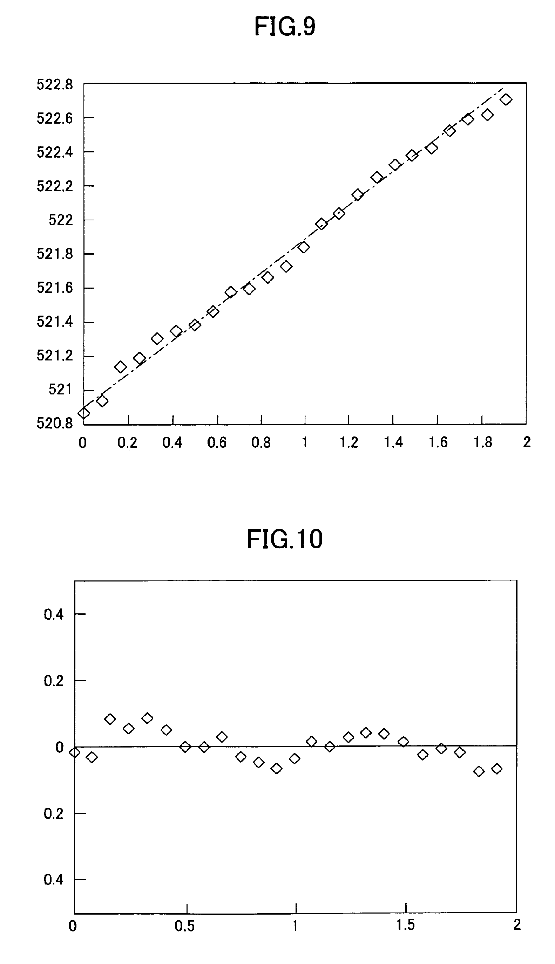

An example of executing a distortion correcting data calculation procedure relating to the image acquired by the camera according to the present invention is set forth below using Figs. 8 and 9. The following description assumes that imaging with the camera 1017 is conducted by the image processing unit 2011 under an instruction from the CPU 201. And the X-axial and Y-axial movements of the component mounting head driven by the X-axis motor 1012 and the Y-axis motor 109 are conducted by the driving circuits 205 and 206, under an instruction from the CPU 201 respectively=. And also the rotation of the component mounting head is conducted by the driving circuit 207 that controls the θ-axis motor 1016 under an instruction from the CPU 201.

First, the distortion correcting jig 501 is imaged with the camera 1017 (step S81). Next, an angular shift B between the I-coordinate axis of the image coordinates of the camera 1017 and the x-coordinate axis of the distortion correcting jig 501 are detected (step S82). In this way, the image processing unit 2011 can be used to detect the angular shift B between the I-coordinate axis of the image coordinates of the camera 1017 and the x-coordinate axis of the distortion correcting jig 501. The detection is based upon the pattern image of the distortion correcting jig 501 that is acquired using the camera 1017, and the angle detected will be, for example, an inclination angle of a straight line connecting a gravitational position of the x-axial pattern sequence, with respect to the I-coordinate axis. Steps 81 and 82 may be skipped if the I-coordinate axis of the camera 1017 and the x-axis of the distortion correcting jig 501 are trued up (positioned) beforehand in any way other than the above so as to make the two axes parallel to each other.

After the above detection, the θ-axis motor 1016 is controlled so that a relative angle of the x-coordinate axis of the distortion correcting jig 501 with respect to the I-coordinate axis of the image coordinates of the camera 1017 is a greater than zero (step S83). The angle a will be described later herein. After the relative angle a of the x-coordinate axis of the distortion correcting jig 501 with respect to the I-coordinate axis of the image coordinates of the camera 1017 has thus been set, the camera 1017 images the grid point sequence pattern formed on the distortion correcting jig 501 and executes highly accurate distortion correction without influenced by the quantization error (step S84). Upon completion of the distortion correction, the constants (k1, k2, k3, etc.) in expression (1) described later are stored as distortion correcting data into the RAM 202, for example (step S85).

As a result, rotational angle shifts are caused between the (x, y) coordinate system defined by the grids on the distortion correcting jig 501 and an (X, Y) coordinate system defined by the stage (108, 1011), and between the (x, y) coordinate system and the image (I, J) coordinate system of the camera 1017. And data obtained from the distortion correcting jig 501, the stage and the camera are recorded having the rotational angle shifts with each other. However, on the basis of the distortion correction results carried out at the step S84 (the distortion correcting data such as the constants k1, k2, and k3), the image (I, J) coordinate system of the camera 1017 is converted, one for one, into the (x, y) coordinate system defined by the grids on the distortion correcting jig 501. Also, the (x, y) coordinate system can be converted into the (X, Y) coordinate system defined by the stage (108, 1011), during primary conversion. For these reasons, the (X, Y) coordinates of the stage (108, 1011) can be uniquely identified from the image (I, J) coordinates of the camera 1017.

Next, distortion correcting step S84 that the image processing unit 2011 executes for the camera 1017 is described below in detail along with the flow chart in Fig.8. First, inputting the image of the distortion correcting jig 501 acquired by the camera 1017 with the angle a assigned as the relative angle of the x-coordinate axis of the distortion correcting jig 501 with respect to the I-coordinate axis of the camera 1017 (step S841). Then, carrying out binarization of the input image (step S842). Next, detecting round regions present in the binarized image (step S843), after which, calculating gravitational coordinates of each round region (step S844). Finally, allocating (x, y) coordinates of an actual size equivalent that are defined by the orthogonal grids on the distortion correcting jig 501 to the calculated gravitational coordinates (step S845) and then establishing final expression (1) described later (step S846).

A method of converting the (I, J) coordinates of the image acquired by the camera 1017, into the (x, y) coordinates of the actual size defined by the orthogonal grids on the distortion correcting jig 501, is described below. When the lens distortions in radial and tangential directions are taken into account, the (I, J) coordinates of the image acquired by the camera 1017 are converted into the (x, y) coordinates of the actual size defined by the orthogonal grids on the distortion correcting jig 501, the conversion is carried out based upon expression (1) shown below. Expression (1) can be applied only when an origin of the image coordinate system overlaps with that of the coordinate system defined by the orthogonal grids on the distortion correcting jig 501. Offsets can be added when the origins of the two coordinate systems do not overlap. The constants k1, k2, k3 in expression (1) can be determined as follows. At first, assigning grid points (n = 0, 1, etc. up to N) from the image acquired by camera the 1017, and calculating coordinate data from the image coordinates (In, Jn) and corresponding grid point coordinates (xn, yn) on the distortion correcting jig. Next, applying the calculated coordinated data to expression (2) shown below, and then calculating values of k1, k2, k3 that minimize ΣDn, a sum of squared deviations. The calculated k1, k2, k3 values are stored into, for example, the RAM 202, as the distortion correcting data in step S85 of Fig. 8.

$$x = k1 \times (I^2 - J^2) \times I + k2 \times (I^2 + J^2 + 2I^2) + k3 \times 2 \times I \times J$$

$$y = k1 \times (I^2 - J^2) \times J + k3 \times (I^2 + J^2 + 2J^2) + k2 \times 2 \times I \times J \quad \cdots\cdots\cdots \text{ expression (1)}$$

$$D_n = (x_n - k1 \times (I^2_n + J^2_n) \times I_n + k2 \times (I^2_n + J^2_n + 2I^2_n) + k3 \times 2 \times I_n \times J_n)^2$$

$$+ (y_n - k1 \times (I^2_n + J^2_n) \times J_n + k3 \times (I^2_n + J^2_n + 2J^2_n) + k2 \times 2 \times I_n \times J_n)^2$$

$$\cdots\cdots\cdots \text{ Expression (2)}$$

A method for correcting any distortion of the image acquired with the camera 1017 has been described above. The image quantization error that becomes a problem during the distortion correction characterizing the present invention, and a method for suppressing any impacts of the quantization error are described below. Fig. 9 shows measurement results obtained by moving the distortion correcting jig 501 through 120 $\mu$m at 5-$\mu$m pitches in an I-direction of image coordinates and then measuring, with a camera of 60-$\mu$m image resolution, a gravitational position of one circularly marked point on the distortion correcting jig. In Fig. 9, movement distances of the distortion correcting jig 501 that are expressed in terms of pixel equivalent data with a starting position as 0 are plotted on a horizontal axis, and measured I-coordinates of the gravitational position of the mark on the image are plotted on a vertical axis. The single-dotted line shown in Fig. 9 is an approximate line calculated from the measurement results by using the least squares method.

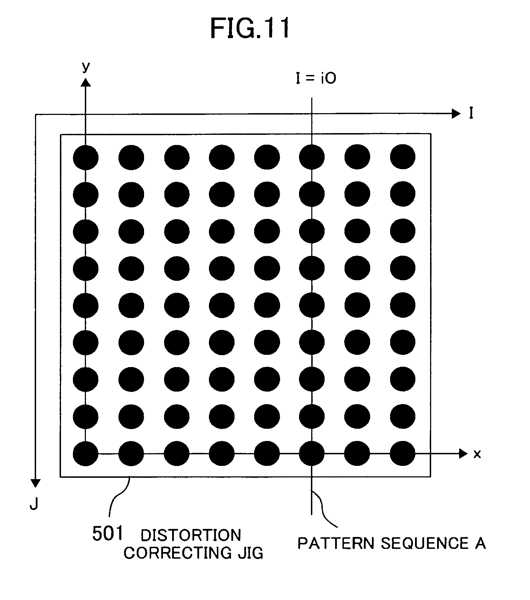

In Fig. 10, the movement distances of the distortion correcting jig 501 that are expressed in terms of pixel equivalent data with the starting position as 0 are plotted on a horizontal axis, and differences in distance between the approximate line of Fig. 9 and various measuring positions are plotted in terms of pixel data on a vertical axis. Fig. 10 indicates that the error changes at periods of one pixel in a range of about $\pm 0.1$ pixel. For this reason, in case an angle between the (x, y) coordinate system defined by the pattern of the distortion correcting jig 501 and the (I,J) image coordinate system defined by the camera 1017 for imaging the distortion correcting jig 501 is nearly of 0 degree, as in Fig. 11, a pattern sequence A on the distortion correcting jig 501 that ought to be positioned on a line of I=i0 will fluctuate in a range of I = iO$\pm$0.1 due to superimposition of the quantization error shown in Fig. 10. In this case, even if the distortion correction is executed, it is difficult to obtain a distortion correcting data with high reliability. The pattern sequence A here refers to one arbitrary sequence of circular marks given on the line shown as the pattern sequence A in Fig. 11. Since the error changes by the relative position between the pattern of the distortion correcting jig 501 and the camera 1017, it cause the problem that different correction data needs to be created with each correction process.

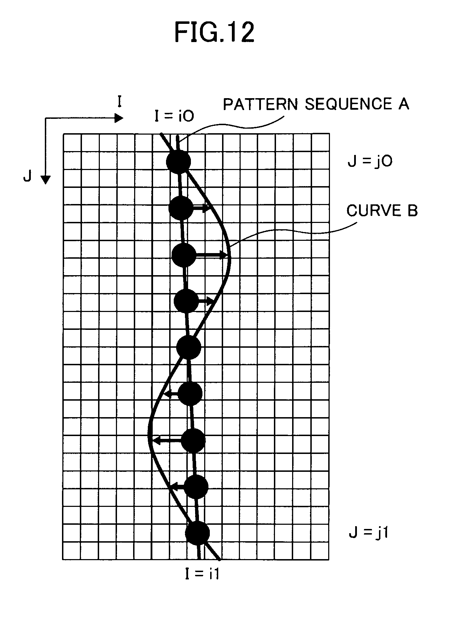

To solve above problem, this invention applies the method as described in step S83 of Fig. 8⑦. As is explained before by referring Fig. 8, the (x, y) coordinate system defined by the pattern of the distortion correcting jig 501 is rotated to form the angle a which is greater than zero, with respect to the (I, J) coordinate system of the imaging surface of the camera 1017 for imaging the distortion correcting jig 501. This state of the (x, y) coordinate system is shown in Fig. 12. In Fig. 12, the pattern sequence A is linearly disposed from image coordinates (i0, j0) to (i1, j1). Arrows extending from the individual circular pattern points in Fig. 12 schematically represent directions in which the quantization error is caused, and a magnitude of the quantization error, and each of the arrows reflects the results shown in Figs. 9 and 10. When measured on the image, therefore, the pattern sequence A will be observed in such a curvilinear form as exaggeratedly shown in the form of curve B. As shown in Fig. 12, periodic influence of the quantization error appears at each point of the pattern. However, since the pattern sequence A is shifted through one pixel at a region from the image coordinates (i0, j0) to (i1, j1) in the I-direction, the quantization error equally appears in leftward and rightward directions of the pattern sequence exactly at one-period intervals (periodically). By calculating an approximate line from the curve B by using least squares approximation, the quantization error will be canceled. And the calculated approximation line will be closer to the proper pattern sequence A. The pixel size and grid point pattern size shown in Fig. 12 are for schematic description purposes only, and both differ from actual ones. A relationship between the foregoing angle a and the image coordinates (i0, j0), (i1, j1) is shown in expression (3).

$$\alpha = \arctan\left[\frac{i1-i0}{j1-j0}\right] \quad \cdots\cdots\cdots \text{ Expression (3)}$$

While the I-coordinates in Fig. 12 are shifted through one pixel at the region from (i0, j0) to (i1, j1), this shift in position can be greater, and if the shift is greater than a one-pixel distance, a greater cancellation effect is anticipated against the quantization error.

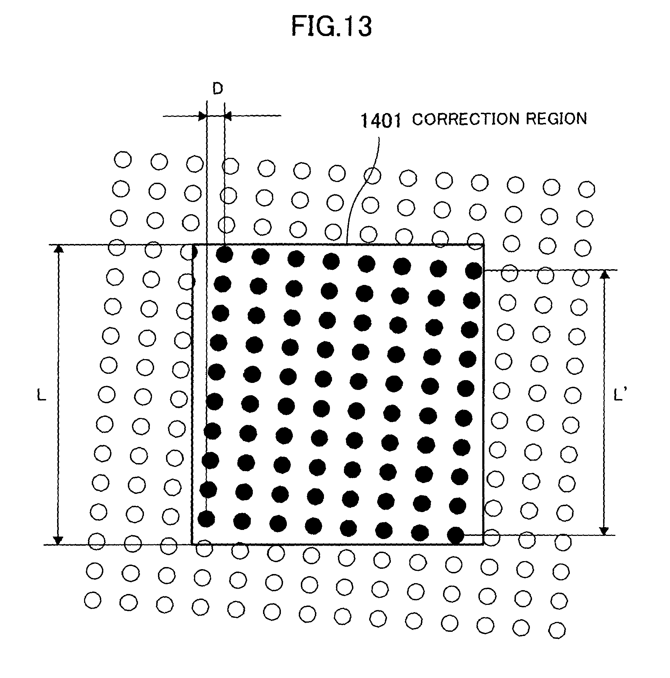

Fig. 13 shows an example of an image of the distortion correcting jig 501 imaged after the (x, y) coordinate system defined by the pattern of the distortion correcting jig 501 has been rotated with respect to the (I, J) coordinate system of the imaging surface of the camera 1017. White circles and black ones in Fig. 13 represent a correction pattern image acquired. Reference number 1401 denotes a correction region. Distortion is corrected using the internal pattern of the correction region. An external pattern of the correction region is shown as the sequence of white circles, and the internal pattern of the correction region is shown as the sequence of black circles. Symbol L denotes length of one side of a square correction region on the image. Length of a longer side or shorter side is used for a rectangular correction region. Symbol D denotes the number of pixels equivalent to a change in position, caused when either the camera 1017 or the distortion correcting jig 501 is rotated relative to the other in the correction region. The angle a in step S83 of Fig. 8 is calculated as: a = arctan (D/L).

As described above, by rotating the x-coordinate axis of the distortion correcting jig through the angle a with respect to the I-coordinate axis of the camera in correcting the distortion due to the camera lens, it makes possible that a quantization error appears equally in the leftward and rightward directions of the pattern sequence on the distortion correcting jig at fixed periods during camera imaging of the pattern sequence. According to the first embodiment of the present invention, the quantization error can be canceled and reduced, thus any variations in the distortion correcting data (constants k1, k2, k3, etc.) obtained during each distortion correcting process (after each replacement of the component mounting head) are reduced, and consequently it makes possible to perform a highly accurate mounting of electronic components, based upon highly reproducible measurement of the component positions.

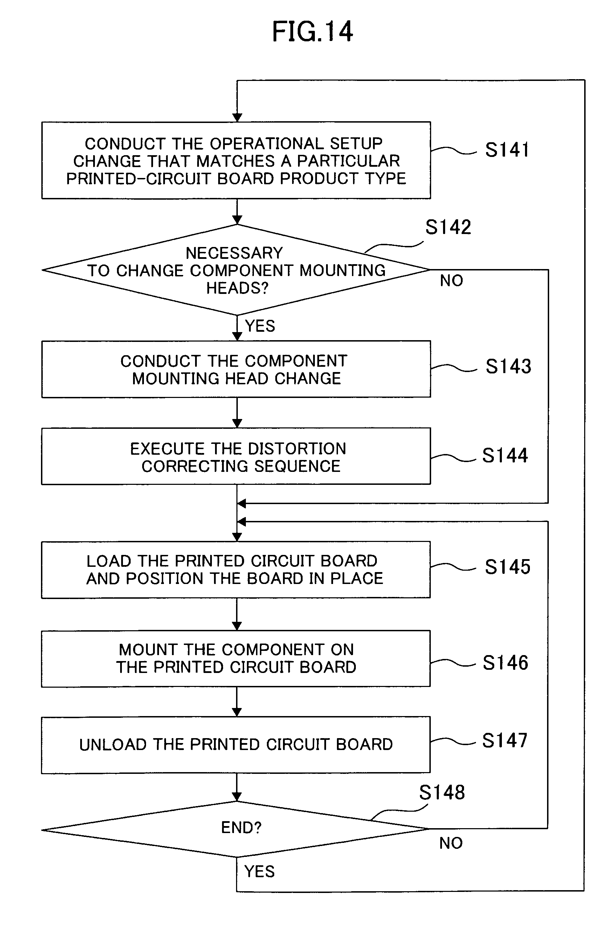

An operational sequence of the electronic component mounting apparatus, inclusive of the method for correcting any distortion of the component position recognizing camera according to the present invention is next described using Fig. 14. First, an operational setup change takes place in step S141 to set up the mounting apparatus for operation associated with a particular printed-circuit board product type. Next, an appropriate mounting head is selected in steps S142 and S143 according to the kind of electronic component which the mounting apparatus is to mount. After a component-mounting head change, a distortion correcting sequence is executed in step S144 since the change is likely to disturb the relationship in relative position between the camera 1017 and the component mounting head 107. The distortion correcting sequence is the succession of steps S81 to S85 shown in Fig. 8. The execution of the sequence completes the setup of the mounting apparatus for component mounting on the printed circuit board. Subsequently, the printed circuit board is loaded (step S145), then the electronic component is mounted thereon (step S146), and upon completion of mounting of all necessary electronic components, the printed circuit board is unloaded (step S147). Board loading step S145 corresponds to step S41 of Fig. 4, component mounting step S146 to steps 42-48 of Fig. 4, and board unloading step S147 to step S49 of Fig. 4. In step S148, if a printed circuit board to be next processed is present, control is returned to step S145 to repeat component mounting. If no such board is present, control is returned to step S141 to allow an operational setup change for processing a printed circuit board of another product type.

(Second Embodiment)

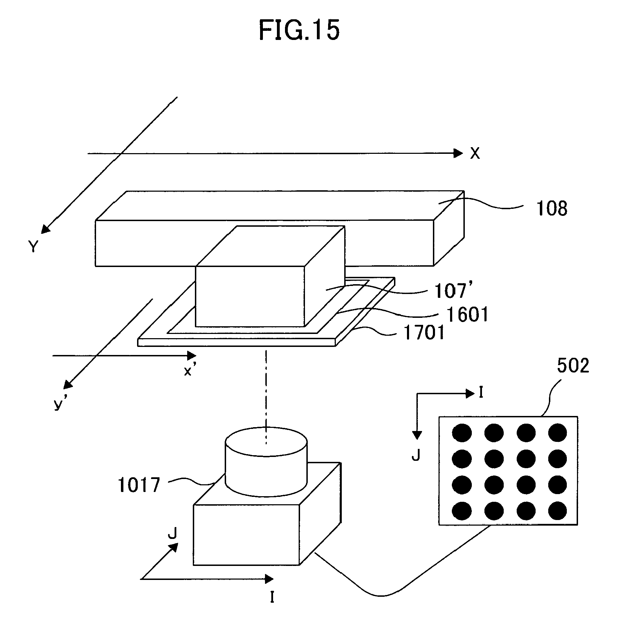

Next, a second embodiment of an electronic component mounting apparatus according to the present invention will be described using Figs. 15 to 17.

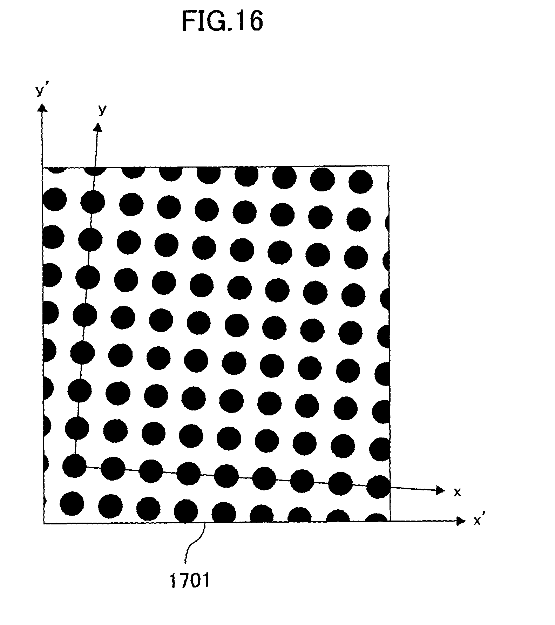

The second embodiment differs from the first embodiment in that a component mounting head 107' is of a non-rotary type without a θ-axis motor 1016, and in that a distortion correcting jig 1701 is constructed so that an (x', y') coordinate system defined with an external shape of the jig as a reference, is rotated through the angle a described in the first embodiment, with respect to an (x, y) coordinate system defined by a grid-shaped pattern. Fig. 15 is a structural view that shows a peripheral region of the component position recognizing camera 1017 existing during calculation of its distortion correcting data. As shown in an example 502 of an image acquired by the camera 1017, coordinates present on the image are defined as I in a rightward direction of a horizontal axis, and as J in a downward direction of a vertical axis. In addition, as described above, the component mounting head 107' in the second embodiment neither has a θ-axis motor 1016 nor rotates. In order that as shown in Fig. 16, therefore, the (x', y') coordinate system defined with the external shape of the distortion correcting jig 1701 as a reference will be parallel to the imaging (I, J) coordinate system of the camera 1017, the distortion correcting jig 1701 is retained by the component mounting head 107' via a distortion correcting jig retainer 1601 by which the jig 1701 is retained in a positioned condition with the external shape thereof as a reference beforehand. The description of the second embodiment assumes that alignment between the (I, J) coordinate system of the camera 1017 and the (X, Y) coordinate system of the stage (108, 1011) is conducted separately.

Fig. 16 illustrates the distortion correcting jig 1701 used in the structure of Fig. 15. The (x', y') coordinate system defined with the external shape of the jig as a reference, is rotated through the angle a described in the first embodiment, with respect to the (x, y) coordinate system defined by the grid-shaped pattern. As a result, a quantization error appears equally in the leftward and rightward directions of the pattern sequence A at fixed periods as shown in Fig. 12. When the straight line of this point sequence is detected using least squares approximation, for example, the quantization error will be offset and the line detected will be closer to the original pattern sequence A.

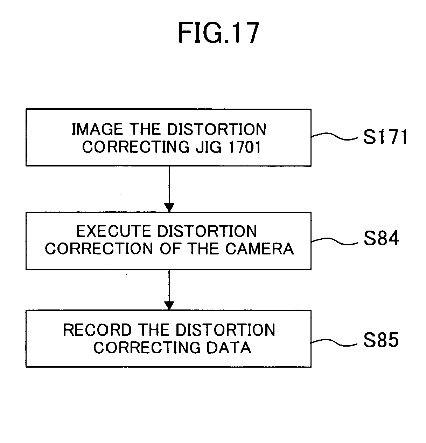

Next, a distortion correcting procedure relating to the camera in the second embodiment of the present invention is set forth below using Fig. 17. That is to say, in step S171, the component position recognizing camera 1017 images the distortion correcting jig 1701 that has been positioned in the (x', y') coordinate system of the external-shape reference and then retained by the component mounting head 107'. This imaging operation is followed by the correction of distortion in step S84. Details of the distortion correction are the same as those shown in step S84 of Fig. 8 relating to the first embodiment. After the execution of the distortion correction, the constants k1, k2, k3, etc. in foregoing expression (1) obtained as a result will be stored as distortion correcting data in step S85.

Distortion correction has been described above. Description of other factors, that is, the apparatus configuration, system configuration, and operational flow of the electronic component mounting apparatus, is omitted herein since these factors are the same as in the first embodiment.

As described above, according to the second embodiment of the present invention, as in the first embodiment, when distortion due to the camera lens is corrected, the x-coordinate axis of the distortion correcting jig 501 is rotated through the angle a with respect to the I-coordinate axis of the camera 1017, and as a result, a quantization error appears equally in the leftward and rightward directions of the pattern sequence on the distortion correcting jig at fixed periods during camera imaging of the pattern sequence. This method offsets and reduces the quantization error, thus reduces any variations in the distortion correcting data (constants k1, k2, k3, etc.) obtained during each distortion correcting process, and consequentially allows highly accurate mounting of electronic components, based upon highly reproducible measurement of the component positions.

According to the present invention, when the distortion correcting data for the correction of distortion due to the lens of the camera is calculated, the magnitude of the quantization error caused during the imaging of the image distortion correcting jig to be measured can be reduced, which, in turn, reduces any variations in the distortion correcting data obtained during each distortion correcting process (after each component-mounting head change), and consequentially allows highly accurate mounting of electronic components, based upon highly reproducible measurement of the component positions.

The invention may be embodied in other specific forms without departing from the spirit or essential characteristics thereof. The present embodiment is therefore to be considered in all respects as illustrative and not restrictive, the scope of the invention being indicated by the appended claims, rather than by the foregoing description, and all changes which come within the meaning and range of equivalency of the claims are therefore intended to be embraced therein.

**Claims**

1.  An electronic component mounting apparatus, comprising:

    a component mounting head with a suction nozzle for holding an electronic component by suction, the mounting head being adapted to move in an X-direction and a Y-direction;
    a component position recognizing camera for acquiring an image of the electronic component suction-held by the suction nozzle of the component mounting head, by imaging the electronic component on an imaging surface defined in an (I, J) coordinate system; and
    an image processing unit adapted to conduct a distortion correction based upon distortion correcting data stored within a storage unit after being arithmetically obtained for the image of the electronic component that is acquired from the component position recognizing camera, and thereby recognize a position of the electronic component on the basis of the image subjected to the distortion correction;

    wherein: a distortion correcting jig on which is formed a distortion correcting pattern defined in an (x, y) coordinate system is retained by the component mounting head; and
    after the (x, y) coordinate system with the distortion correcting pattern defined therein has been rotated through a predetermined angle with respect to the (I, J) coordinate system defined on the imaging surface of the component position recognizing camera, the component position recognizing camera acquires an image of the distortion correcting pattern, the image processing unit calculates the distortion correcting data on the basis of the image of the distortion correcting pattern and then stores the calculated data into the storage unit.

2.  The electronic component mounting apparatus according to claim 1,
    wherein, in calculating the distortion correcting data from the distortion correcting pattern image acquired by the component position recognizing camera, the image processing unit calculates the distortion correcting data from a sequence of orthogonal grid points on the distortion correcting pattern by an approximation using the least squares method.

3.  The electronic component mounting apparatus according to claim 1, further comprising:

    control means adapted such that when the distortion correcting pattern is imaged with the component position recognizing camera, the control means controls the (x, y) coordinate system to rotate, with the distortion correcting pattern defined therein, through the predetermined angle with respect to the (I, J) coordinate system defined on the imaging surface of the component position recognizing camera.

4.  The electronic component mounting apparatus according to claim 3,
    wherein the control means includes a motor that rotates the component mounting head about a vertical axis thereof with the distortion correcting jig retained by the mounting head.

5.  The electronic component mounting apparatus according to claim 1,
    wherein an external-shape reference rotated through the predetermined angle relative to the (x, y) coordinate system having the distortion correcting pattern defined therein is formed for the distortion correcting jig, the distortion correcting jig being further retained with the formed outside-dimensional reference positioned at the component mounting head.

6. The electronic component mounting apparatus according to claim 1, wherein the distortion correcting pattern is formed with a point-symmetric graphic or x-y directionally line-symmetric graphic disposed on a grid point sequence defined in the (x, y) coordinate system.

7. The electronic component mounting apparatus according to claim 1, wherein the component position recognizing camera is constructed using a CCD-based sensor or a MOS-based sensor.

8. A method for mounting an electric component on a circuit board, comprising the steps of:

holding an electronic component by suction with a component mounting head;
acquiring an image of the electronic component suction-held by the component mounting head with a component position recognizing camera;
conducting a distortion correction, based upon distortion correcting data stored in a memory, of the image of the electronic component acquired from the component position recognizing camera;
recognize a position of the electronic component suction-held by the component mounting head on the basis of the image subjected to the distortion correction; and
mounting the electronic component on a circuit board by correcting the position of the electronic component suction-held by the component mounting head by using information obtained by the recognizing,

wherein in the step of conducting a distortion correction, said distortion correction data is obtained by

rotating a (x, y) coordinate system of a distortion correcting pattern formed on a distortion correcting jig suction-held by the component mounting head with respect to a (I, J) coordinate system defined on an imaging surface of the camera through a predetermined angle;
calculating the distortion correction data from an image of the distortion correction pattern obtained by the component position recognizing camera; and
storing the distortion correction data in a memory.

9. A method for mounting an electric component on a circuit board according to claim 8, further comprising the step of:

during the calculation of the distortion correcting data by use of the distortion correcting pattern image acquired by the camera, an approximate line of a grid point sequence formed on the distortion correcting pattern is calculated by using the least squares method.

10. A method for mounting an electric component on a circuit board according to claim 8, wherein the distortion correcting pattern is formed with a point-symmetric graphic or x-y directionally line-symmetric graphic disposed on a grid point sequence defined in the (x, y) coordinate system.

11. A method for mounting an electric component on a circuit board according to claim 8, wherein the component position recognizing camera is constructed using a CCD-based sensor or a MOS-based sensor.

# FIG.1

# FIG.2

202 — RAM

201 — CPU

203 — ROM

204 — INTERFACE

2011 — IMAGE PROCESSING UNIT — CAMERA — 1017

209 — KEYBOARD DRIVER — KEYBOARD — 2010

210 — MONITOR

205 — DRIVING CIRCUIT — X-AXIS MOTOR — 2012

206 — DRIVING CIRCUIT — Y-AXIS MOTOR — 109

207 — DRIVING CIRCUIT — Θ-AXIS MOTOR — 1015, 1016

208 — DRIVING CIRCUIT — UP/DOWN SHAFT MOTOR — 1014

EP 2 200 418 A2

# FIG.3

| STEP | X[mm] | Y[mm] | Z | FDR NO. |
|------|-------|-------|-----|---------|
| 001 | X1 | Y1 | Z1 | 101(P1) |
| 002 | X2 | Y2 | Z2 | 101(P1) |
| 003 | X3 | Y3 | Z3 | 103(P2) |
| 004 | X4 | Y4 | Z4 | 105(P3) |
| 005 | X5 | Y5 | Z5 | 101(P1) |
| 006 | X6 | Y6 | Z6 | 101(P1) |
| 007 | X7 | Y7 | Z7 | 107(P4) |
| 008 | X8 | Y8 | Z8 | 101(P1) |
| 009 | X9 | Y9 | Z9 | 109(P5) |
| 010 | X10 | Y10 | Z10 | 101(P1) |

# FIG.4

```
┌─────────────────────────────┐
│ POSITION THE PRINTED CIRCUIT │      S41
│ BOARD P AT THE POSITIONING   │
│ UNIT 5                       │
└─────────────────────────────┘
              │
              ▼ ◄─────────────────────┐
┌─────────────────────────────┐       │
│   READ OUT MOUNTING DATA     │  S42  │
└─────────────────────────────┘       │
              │                        │
              ▼                        │
┌─────────────────────────────┐       │
│  SUCTION-HOLD THE COMPONENT  │  S43  │
└─────────────────────────────┘       │
              │                        │
              ▼                        │
┌─────────────────────────────┐       │
│    START TO MOVE THE HEAD    │  S44  │
│    TO A POSITION ABOVE THE   │       │
│    PRINTED CIRCUIT BOARD     │       │
└─────────────────────────────┘       │
              │                        │
              ▼                        │
┌─────────────────────────────┐       │
│ RECOGNIZE THE SUCTION        │  S45  │
│ POSITION OF THE COMPONENT    │       │
└─────────────────────────────┘       │
              │                        │
              ▼                        │
┌─────────────────────────────┐       │
│ CORRECT THE MOUNTING         │  S46  │
│ POSITION ON THE BASIS OF THE │       │
│ COMPONENT RECOGNITION        │       │
│ POSITION                     │       │
└─────────────────────────────┘       │
              │                        │
              ▼                        │
┌─────────────────────────────┐       │
│     MOUNT THE COMPONENT      │  S47  │
└─────────────────────────────┘       │
              │              S48       │
              ▼                        │
         ╱─────────╲                   │
        ╱   END?    ╲ ──── NO ─────────┘
         ╲─────────╱
              │ YES
              ▼
┌─────────────────────────────┐
│   UNLOAD THE PRINTED         │  S49
│   CIRCUIT BOARD              │
└─────────────────────────────┘
```

# FIG.5

## FIG.6

501  DISTORTION CORRECTING JIG

## FIG.7

# FIG.8

IMAGE THE DISTORTION CORRECTING
JIG 501 WITH THE CAMERA 1017 — S81

DETECT THE ANGULAR SHIFT $\beta$ BETWEEN THE
I-COORDINATE AXIS OF THE IMAGE COORDINATES
OF THE CAMERA 1017 AND THE x-COORDINATE
AXIS OF THE DISTORTION CORRECTING JIG 501 — S82

CONTROL THE $\theta$-AXIS MOTOR 1016 TO OBTAIN A
PREDETERMINED RELATIVE ANGLE $\alpha$ BETWEEN THE
I-COORDINATE AXIS OF THE IMAGE COORDINATES OF
THE CAMERA 1017 AND THE x-COORDINATE AXIS OF
THE DISTORTION CORRECTING JIG 501 — S83

EXECUTE THE DISTORTION
CORRECTION OF THE CAMERA 1017 — S84

INPUT AN IMAGE OF THE
DISTORTION CORRECTING JIG 501 — S841

BINARIZATION — S842

DETECT EACH ROUND REGION — S843

DETECT THE GRAVITATIONAL
COORDINATES OF EACH CIRCLE — S844

ALLOCATE ACTUAL-SIZE EQUIVALENT
COORDINATES TO THE GRAVITATIONAL
COORDINATES OF EACH CIRCLE — S845

ESTABLISH FINAL FORMULA (1) FOR CONVERTING
THE CAMERA COORDINATES (I, J) INTO THE
ACTUAL-SIZE EQUIVALENT COORDINATES (x, y) — S846

RECORD THE DISTORTION CORRECTING DATA — S85

## FIG.9

## FIG.10

# FIG.11

501  DISTORTION
     CORRECTING JIG

PATTERN SEQUENCE A

# FIG.12

# FIG.13

1401 CORRECTION REGION

# FIG.14

```
                    ┌─────────────────────────────────┐
                    │  CONDUCT THE OPERATIONAL SETUP   │ ～ S141
                    │  CHANGE THAT MATCHES A PARTICULAR │
                    │  PRINTED-CIRCUIT BOARD PRODUCT TYPE│
                    └─────────────────────────────────┘
                                  │
                                  ▼                S142
                         ◇ NECESSARY ◇
                      ◇ TO CHANGE COMPONENT MOUNTING ◇─── NO
                         ◇   HEADS?   ◇
                              │ YES
                              ▼
                    ┌─────────────────────────────────┐
                    │      CONDUCT THE COMPONENT       │ ～ S143
                    │      MOUNTING HEAD CHANGE        │
                    └─────────────────────────────────┘
                              │
                              ▼
                    ┌─────────────────────────────────┐
                    │       EXECUTE THE DISTORTION     │ ～ S144
                    │       CORRECTING SEQUENCE        │
                    └─────────────────────────────────┘
                              │
                              ▼
                    ┌─────────────────────────────────┐
                    │   LOAD THE PRINTED CIRCUIT BOARD │ ～ S145
                    │   AND POSITION THE BOARD IN PLACE│
                    └─────────────────────────────────┘
                              │
                              ▼
                    ┌─────────────────────────────────┐
                    │       MOUNT THE COMPONENT ON     │ ～ S146
                    │      THE PRINTED CIRCUIT BOARD   │
                    └─────────────────────────────────┘
                              │
                              ▼
                    ┌─────────────────────────────────┐
                    │  UNLOAD THE PRINTED CIRCUIT BOARD│ ～ S147
                    └─────────────────────────────────┘
                              │
                              ▼            S148
                         ◇  END?  ◇─── NO
                              │ YES
```

# FIG.15

# FIG.16

1701

# FIG.17

| | |
|---|---|
| IMAGE THE DISTORTION CORRECTING JIG 1701 | S171 |

↓

| | |
|---|---|
| EXECUTE DISTORTION CORRECTION OF THE CAMERA | S84 |

↓

| | |
|---|---|
| RECORD THE DISTORTION CORRECTING DATA | S85 |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 6241724 A

### Non-patent literature cited in the description

- **Hirofumi Chikatsu ; Yoichi Kunii ; Ryuji Nakata.** Verification of the 3-million-pixel digital still camera accuracy as viewed in terms of digital photogrammetry. *Photogrammetry and Remote Sensing,* 2001, vol. 40 (2), 33-38